# EUROPEAN PATENT APPLICATION

(11) **EP 4 518 051 A1**
(43) Date of publication of application: **05.03.2025**
(21) Application number: 24197686.9
(22) Date of filing: 30.08.2024
(51) Int. Cl.: H02B 1/06, H02B 1/14, H02B 1/32, H02B 1/56

(54) **ALUMINUM SHEET WITH DIELECTRIC COATING ISOLATION BARRIER**

(30) Priority: 31.08.2023 US 202318240521
(71) Applicant: Hamilton Sundstrand Corporation, Charlotte, NC 28217-4578 (US)
(72) Inventor: YANG, Nhia, Roscoe, IL 61073 (US); BELISLE, Francis C., Roscoe, 61073 (US); GACKSTETTER, David, Rockford, IL 61107 (US); CANCIAMILLE, Catherine, Rockford, IL, 61107 (US)
(74) Representative: Dehns

(57) **Abstract**

The present disclosure provides for barrier wall assemblies (e.g., isolation barrier wall assemblies having embossed aluminum sheets coated with dielectric coatings). More particularly, the present disclosure provides for barrier wall assemblies configured to be positioned between electric power distribution components (e.g., positioned between power distribution components of different voltages or different criticality so that a fault in one section or component functional group will not affect adjacent areas).

## Description

### TECHNICAL FIELD

The present disclosure relates to barrier wall assemblies (e.g., isolation barrier wall assemblies having embossed aluminum sheets coated with dielectric coatings) and, more particularly, to barrier wall assemblies configured to be positioned between electric power distribution components (e.g., positioned between power distribution components of different voltages or different criticality so that a fault in one section or component functional group will not affect adjacent areas).

### BACKGROUND

In general, there is a need to have a barrier wall construction between power distribution components of different voltages or different criticality so that a fault in one section or component functional group will not affect the adjacent areas. For example, for line replaceable units (LRUs) with requirements for functional and physical isolation between components or between types of voltages, there can be a need for a construction barrier (e.g., wall or enclosure) to prevent an internal fault on a component or chassis section from propagating into an adjacent section or outside of the chassis.

The requirement for isolation can mean in addition to physical spacing there are physical features that prevent heating or electrical arcing from propagating the dissimilar function or voltage components. Isolation barriers can include restrictive design features with the physical barrier having substantially no ventilation holes (e.g., the only holes allowed are minor openings, such as manufacturing features like chassis sheet metal corner breaks, etc.). Therefore, the isolation barrier can be a fault isolation feature and be intended to contain a fault at the origination section or panel zone and to prevent fault propagation.

In general, substantially no air ventilation cooling exchanges across an isolation barrier, so that an over heat event in one area or section does not result in overheating of the adjacent component chassis section.

### BRIEF DESCRIPTION

The present disclosure provides for barrier wall assemblies (e.g., isolation barrier wall assemblies having embossed aluminum sheets coated with dielectric coatings). More particularly, the present disclosure provides for barrier wall assemblies configured to be positioned between electric power distribution components (e.g., positioned between power distribution components of different voltages or different criticality so that a fault in one section or component functional group will not affect adjacent areas).

The present disclosure provides for a barrier wall assembly including a sheet that extends from a first end to a second end, the sheet including a first surface and a second surface; a first dielectric material coating on the first surface, and a second dielectric material coating on the second surface; wherein the sheet includes at least one embossed feature extending from the sheet; and wherein the sheet is configured to be positioned between electrical components so that a fault in one section or component functional group will not affect adjacent areas of the components.

In embodiments, the sheet comprises aluminum.

In embodiments, the first dielectric material coating comprises a thermally conductive insulator to allow the sheet to assist in conduction cooling of the components, while still having voltage protection for preventing fault propagation.

In embodiments, the second dielectric material coating comprises a liquid or film applied insulation coating that is cured to allow uniform coating thickness on the at least one embossed feature of the sheet, and the liquid or film applied insulation coating provides an arc barrier.

In embodiments, the sheet includes a plurality of embossed features extending from the sheet.

In embodiments, where each embossed feature includes a pocket having a thermal pad therein to assist in component heat sink cooling.

In embodiments, the electrical components include components of different voltages or different criticality.

In embodiments, where each embossed feature is configured to surround a height of one of the electrical components.

In embodiments, the sheet does not include vent holes, to contain foreign object debris between areas.

In embodiments, the electrical components comprise power distribution components or equipment, embedded controls, power conversion components, or high voltage motor controllers.

The present disclosure provides for a method for fabricating a barrier wall assembly including providing a sheet that extends from a first end to a second end, the sheet including a first surface and a second surface; coating a first dielectric material coating on the first surface, and coating a second dielectric material coating on the second surface; and embossing at least one embossed feature on the sheet, the at least one embossed feature extending from the sheet; and positioning the sheet between electrical components so that a fault in one section or component functional group will not affect adjacent areas of the components.

In embodiments, the sheet comprises aluminum.

In embodiments, the first dielectric material coating comprises a thermally conductive insulator to allow the sheet to assist in conduction cooling of the components, while still having voltage protection for preventing fault propagation.

In embodiments, the second dielectric material coating comprises a liquid or film applied insulation coating that is cured to allow uniform coating thickness on the at least one embossed feature of the sheet, and the liquid or film applied insulation coating provides an arc barrier.

In embodiments, the sheet includes a plurality of embossed features extending from the sheet.

In embodiments, where each embossed feature includes a pocket having a thermal pad therein to assist in component heat sink cooling.

In embodiments, the electrical components include components of different voltages or different criticality.

embodiments, where each embossed feature is configured to surround a height of one of the electrical components.

In embodiments, the sheet does not include vent holes, to contain foreign object debris between areas.

In embodiments, the electrical components comprise power distribution components or equipment, embedded controls, power conversion components, or high voltage motor controllers.

Also disclosed is a barrier wall assembly that includes an isolation sheet that extends from a first end to a second end, the sheet including a first surface and a second surface, a first dielectric material sheet connected to the first surface, and a second dielectric material sheet connected to the second surface. At least one of the first and second sheets includes at least one recesses formed therein configured to receive a portion of an electrical component. In this embodiment, a combination of the isolation sheet and the first and second dielectric material sheets is configured to be positioned in a housing so that a fault in one section of the housing will not affect an adjacent section of the housing.

In embodiments, the isolation sheet can be aluminum.

In embodiments, the first dielectric material sheet or the second material dielectric sheet comprises a thermally conductive insulator to allow the sheet to assist in conduction cooling of the components, while still having voltage protection for preventing fault propagation.

In embodiments, the isolation sheet is flat.

In embodiments, the wall can be in combination with the electrical components and the electrical components include components of different voltages or different criticality.

In embodiments, wherein the sheet is free from vent holes.

In embodiments, the wall can be in combination with the electrical components, and wherein the electrical components comprise power distribution components or equipment, embedded controls, power conversion components, or high voltage motor controllers.

In embodiments, one or both of the first and second dielectric material sheets can be additively manufactured.

Also disclosed is a method for fabricating a barrier wall assembly. The method can include: providing an isolation sheet that extends from a first end to a second end, the sheet including a first surface and a second surface; connecting a first dielectric material sheet to the first surface; connecting a second dielectric material sheet to the second surface. The at least one of the first and second sheets includes at least one recess formed therein configured to receive a portion of a printed wiring board. The method can also include positioning the isolation sheet and the dielectric material sheet between electrical components in a housing so that a fault in one section of the housing will not in another section of the enclosure.

In embodiments, the can comprises aluminum, can be flat, and/or can be free from hole.

In embodiments, isolation the first dielectric material sheet or the second material dielectric sheet comprises a thermally conductive insulator to allow the sheet to assist in conduction cooling of the components, while still having voltage protection for preventing fault propagation.

The above described and other features are exemplified by the following figures and detailed description.

Any combination or permutation of embodiments is envisioned.

Additional features, functions and applications of the disclosed assemblies, systems and methods of the present disclosure will be apparent from the description which follows, particularly when read in conjunction with the appended figures.

### BRIEF DESCRIPTION OF THE DRAWINGS

The following descriptions should not be considered limiting in any way. With reference to the accompanying drawings, like elements are numbered alike.

Features and aspects of embodiments are described below with reference to the accompanying drawings, in which elements are not necessarily depicted to scale.

Example embodiments of the present disclosure are further described with reference to the appended figures. It is to be noted that the various features, steps, and combinations of features/steps described below and illustrated in the figures can be arranged and organized differently to result in embodiments which are still within the scope of the present disclosure. To assist those of ordinary skill in the art in making and using the disclosed assemblies, systems and methods, reference is made to the appended figures, wherein:
FIG. 1 is a side view of a barrier wall assembly, according to an example embodiment of the present disclosure;
FIG. 2 is a side view of a barrier wall assembly, according to another example embodiment of the present disclosure; and
FIG. 3 is a side view of a barrier wall assembly, according to another example embodiment of the present disclosure.

### DETAILED DESCRIPTION

A detailed description of one or more embodiments of the disclosed apparatus and method are presented herein by way of exemplification and not limitation with reference to the figures.

The example embodiments disclosed herein are illustrative of barrier wall assemblies, and systems of the present disclosure and methods/techniques thereof. It should be understood, however, that the disclosed embodiments are merely examples of the present disclosure, which may be embodied in various forms. Therefore, details disclosed herein with reference to example barrier wall assemblies and associated processes/techniques of fabrication/assembly and use are not to be interpreted as limiting, but merely as the basis for teaching one skilled in the art how to make and use the assemblies/systems and/or alternative assemblies/systems of the present disclosure.

The present disclosure provides for barrier wall assemblies (e.g., isolation barrier wall assemblies having embossed aluminum sheets coated with dielectric coatings). More particularly, the present disclosure provides for barrier wall assemblies configured to be positioned between electric power distribution components (e.g., positioned between power distribution components of different voltages or different criticality so that a fault in one section or component functional group will not affect adjacent areas).

As noted, current practice provides that there can be a need to have a barrier wall construction between power distribution components of different voltages or different criticality so that a fault in one section or component functional group will not affect the adjacent areas. Such barrier wall assemblies would be robustly installed and be part of the assembly so that it is not forgotten to be installed, because it typically does not have an active function. The isolation barrier typically should not have perforation for cooling air holes because an over-heat event going on will not cause a problem with the dissimilar function area or component. The chassis would get some value from the isolation barrier or separation barrier in addition to the function of a barrier. This could be chassis stiffening or even an alignment feature for the assembly.

Some isolation barrier assembly design requirements can include, without limitation: preventing voltage arcs from propagating; can be a fire wall barrier; can be a thermal barrier to prevent heating or hot air for heating other areas of the chassis; and/or can be removable for component access.

For example, for a line replaceable unit (LRU) with requirements for physical isolation between components or types of voltages there can be the need for a barrier to prevent a fault from one section from propagating to an adjacent section of the chassis. The requirement for isolation can mean in addition to physical spacing there are physical features that prevent heating or electrical arcing from propagating to a dissimilar function or voltage components. The isolation barrier construction should have substantially no ventilation holes and can be configured to both contain the fault and prevent propagation.

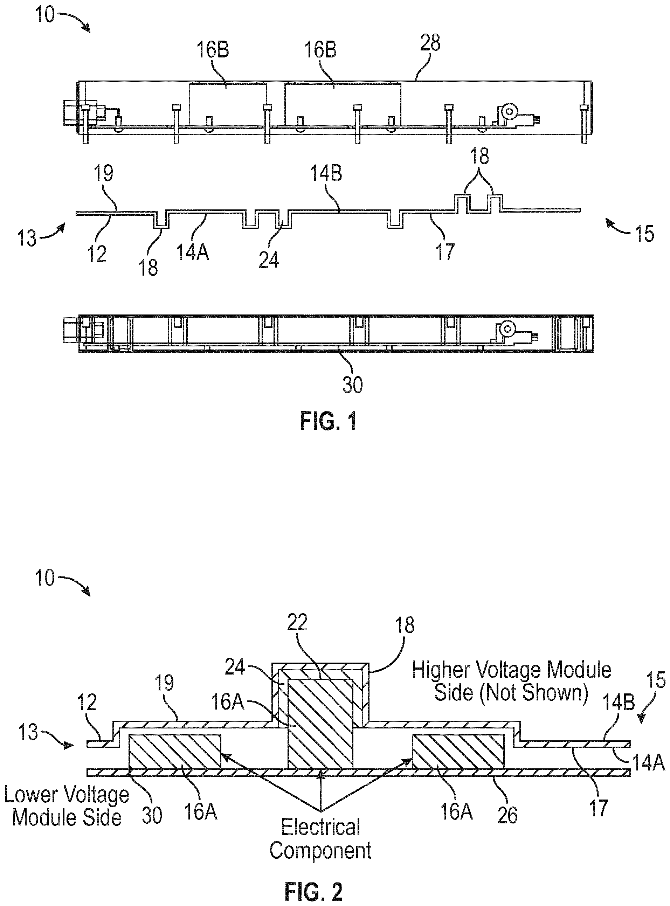

FIG. 1 is a side view of a barrier wall assembly 10, according to an example embodiment of the present disclosure. FIG. 2 is a side view of a barrier wall assembly 10, according to another example embodiment of the present disclosure.

In general, barrier wall assembly 10 is an isolation barrier wall assembly 10 having an embossed sheet/wall 12 (e.g., embossed aluminum sheet/wall 12) that is coated with dielectric coatings 14A, 14B. In general and as discussed further below, barrier wall assembly 10 is configured to be positioned between power distribution components 16A, 16B and 30 (e.g., positioned between power distribution components 16A, 16B of different voltages or different criticality from 30 so that a fault in one section or component functional group will not affect adjacent areas).

As shown in FIGS. 1-2, an isolation barrier wall assembly 10 can be configured to be positioned between components 16A, 16B of dissimilar voltages or functions, with the assembly 10 including a sheet, plate or wall 12 (e.g., aluminum sheet/wall 12) coated with a dielectric material 14A, 14B on both sides of the sheet/wall 12.

In example embodiments and as shown in FIGS. 1-2, sheet 12 extends from a first end 13 to a second end 15, and includes a first or bottom surface 17 and a second or top surface 19. Dielectric material 14A can be coated on first surface 17, and dielectric material 14B can be coated on second surface 19 of sheet 12. In some embodiments, the isolation barrier wall assembly 10 can include a plate/sheet 12 (e.g., an aluminum plate/sheet 12) that is fastened to the chassis that separates the dissimilar voltages (i.e., DC and the AC side) or functionality sides.

The dielectric material 14A closest to some components 16A of concern can be a thermally conductive insulator to allow the sheet/wall 12 (e.g., aluminum sheet/wall 12) to assist in conduction cooling of components 16A, while still having voltage protection for preventing fault propagation.

The dielectric material 14B on the side away (second surface 19) from the components 16A of concern can be a liquid applied insulation coating 14B to allow uniform coating thickness on the embossed features of the sheet 12 (e.g., aluminum sheet 12). The liquid applied insulation coating 14B can be selected to result in the characteristics of an arc and fireproof barrier.

Each embossed feature/area 18 in the sheet 12 (e.g., aluminum sheet 12) can be configured to surround a height of one of the electrical components or parts 16A, 16B, and the sheet 12 generally does not include vent holes, to contain foreign object debris between areas.

In general, sheet 12 provides an isolation barrier between components 16A, 16B having two dissimilar voltages (e.g., components 16A being 28Vdc to 115Vac; and components 16B being 28Vdc to 270Vdc) and/or functions (e.g., essential functions or critical functions of components 16B versus less or non-critical functions of components 16A).

As noted, the dielectric material coating 14A closest to the components 16A on the lower voltage side or less critical function is a thermally conductive insulator to allow the (aluminum) plate/sheet 12 to assist in conduction cooling of components 16A, while still having voltage or arcing protection for preventing fault propagation.

The dielectric material 14B facing away from the components 16A on the lower voltage side or less critical side can be a liquid or film applied insulation coating 14B that is cured to allow uniform coating thickness on the embossed features of the sheet 12. The cured insulation coating 14B (liquid or film when applied) can be selected to be a dielectric and fireproof coating 14B to result in a design/coating that has the characteristic of an arc and fireproof barrier until the electrical fault can be cleared by the system protection.

As noted, each embossed (stamped) feature 18 in the (aluminum) sheet 12 can be configured to surround the height of one or more of the electrical components or parts 16A, 16B. The isolation barrier of the insulated (aluminum) sheet 12 generally contains no vent holes, to which contain or restrict foreign object debris/damage (FOD) between areas. As such, the isolation barrier 10 contains no vents holes which would contain FOD (foreign object damage) within the fault area to prevent contamination or debris or heating from one side failure from affecting the second side.

The sheet 12 (e.g., aluminum sheet 12) with embossed features 18 can provide the following benefits, without limitation: a compliant thermal pad 22 can substantially fill the pockets 24 between the embossed area 18 and electrical components 16A, 16B for thermal conduction to the sheet 12, to assist in component heat sink cooling. Moreover, the embossed features 18 allow for the isolation barrier assembly 10 to be installed closely to printed wiring boards 26, which allows for a smaller overall package. Furthermore, the sheet 12 is coated with dielectric material 14A, 14B and allows for closer installation of the isolation barrier assembly 10 to electrically hot or high voltage components 16A, 16B. The isolation barrier wall assembly 10 can contain an electrical fault within the area or side where the fault originated.

The embossed (aluminum) sheet 12 with dielectric coating 14A, 14B isolation barrier can be applied to embedded controls, power conversion, high voltage motor controllers, and power distribution equipment when there is a need for an isolation barrier.

As shown in FIG. 1, the top surface 19 of sheet 12 can be positioned next to an upper chassis half 28 (e.g., 270Vdc module and upper chassis half 28) of compact equipment, and the bottom surface 17 of sheet 12 can be positioned next to a lower chassis half 30 (e.g., 28Vdc module and lower chassis half 30 with high thermal loss electrical components 16A) of compact equipment.

The embossed features 18 shroud electrical components 16A, 16B on the 270Vdc module (upper chassis half 28) and the 28Vdc module (lower chassis half 30). The embossed features or shrouds 18 can be on both sides/surfaces 17, 19 of sheet 12.

The dielectric coated 14A, 14B (aluminum) sheet 12 with embossed features 18 can be mounted directly onto the chassis 28, 30, and this creates a physical barrier 12 between the upper 28 and lower 30 chassis halves.

As shown in FIG. 2, a thermal pad 22 (e.g., a soft conforming thermal conductive pad 22 such as, for example, a silicone polymer with ceramic filler pad 22) can be sandwiched between the sheet 12 (in one or more pockets 24) and electrical component(s) 16A for heat sinking. The pad 22 is generally applied or positioned next to high loss components 16A.

In general, each chassis 28, 30 includes a printed wiring board assembly 26 (PWBA) with mounted electrical components 16A, 16B.

As noted, there is a need to have a barrier wall assembly 10 between electrical components 16A, 16B (e.g., power distribution components 16A, 16B) of different voltages or different criticality so that a fault in one section or component functional group will not affect the adjacent areas. The assembly 10 would be robustly installed and be part of the assembly so that it is not forgotten to be installed, because it does not have an active function, in some embodiments.

The sheet 12 should not have perforation for cooling air holes because an over-heat event going on shall not cause a problem with the dissimilar function area or component. The chassis 28, 30 would get some value from the isolation barrier or separation barrier assembly 10 in addition to the function of a barrier. This could be chassis stiffening or even an alignment feature for the assembly.

In example embodiments, some isolation barrier wall assembly 10 design requirements can include, without limitation: preventing voltage arcs from propagating; can be a fire wall barrier; can be a thermal barrier to prevent heating or hot air for heating other areas of the chassis; and/or can be removable for component access.

In the above examples, the sheet 12 was an embossed sheet. In another embodiment, the sheet can be flat and can have one or more dielectric material sheets attached to opposing sides thereof. The dielectric material sheets can have depressions formed therein to receive an electrical component therein. An example component can be a printed wiring board in one embodiment. The dielectric material sheets can contact or be separated slightly from the electrical component received in them. The dielectric material sheets can help dissipate heat, for example, an electronic chassis. In one embodiment, the sheets can be formed by additive (or other advanced manufacturing) manufacturing. This can allow the sheets to achieve geometries to receive circuit components that a flat metal-based isolation barrier cannot. Further, by using an advance manufacturing technique, the sheets may cover any exposed areas left by the metal barrier required for mounting or bends and fill unique geometry created by the electrical components. In one embodiment, the sheets may prevent arcing between components or sections of a chassis and limit the need for large spaces between components needed for cooling. In the event of an arc, the dielectric sheets will take the brunt of the damage and then just the sheet(s) could be replaced and flat sheet does not need to be. It shall be understood that the following disclosed embodiment can be combined with the above discussion and vice-versa.

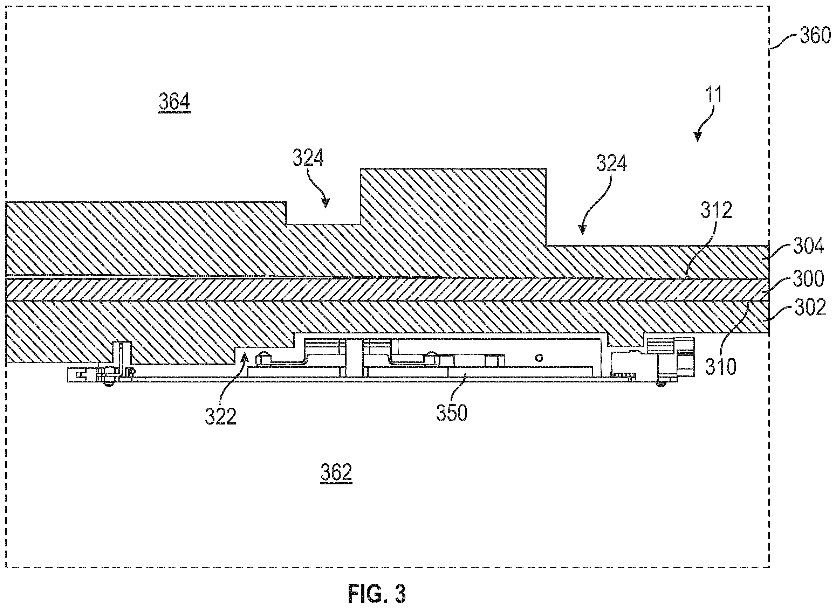

FIG. 3 shows another assembly 11 according to one embodiment. The assembly includes an isolation layer 300. The isolation 300 can be formed of aluminum in one embodiment. The isolation layer 300 can be flat an can be free from vent holes in one embodiment.

As shown in the isolation layer 300 includes first side 310 and a second side 312. One or both of the first and second sides 310, 312 can have a dielectric layer 302, 304 connected thereto. The layers 302, 304 can be removably attached or fixedly attached to the isolation layer. In one embodiment, the layers 302, 304 are formed of a thermal conductive insulator. In one embodiment, as above, the layers 302, 304 may assist in conduction cooling of the components, while still having voltage protection for preventing fault propagation. The layers 302, 304 can be formed by any advanced manufacturing technique including additive manufacturing. This applies to any insulating or dielectric layer disclosed in this or other embodiments.

One or both of the layers 302, 304 can be formed so they include recess 322, 324 formed therein. The recesses 322, 324 can be sized and arranged to receive any type of electrical components. For example, the recesses 322, 324 can receive a printed wiring board 350 in one embodiment. The electrical components can also be power distribution components or equipment, embedded controls, power conversion components, or high voltage motor controllers whether implemented on a printed wiring board or not.

As shown herein, any assembly 10/11 can be provided into housing/enclosure 360 to divide the housing into at least two portions 362, 364. The assemblies 10/11 can keep a fault in one section/portion from affecting an adjacent section/portion.

There are many benefits of the assemblies 10/11, systems and methods of the present disclosure, including, without limitation, providing a barrier between dissimilar voltages or dissimilar functions and having no vents holes to contain foreign object damage within the fault area and to prevent contamination or heating from one side to the second side; provides for a sheet or wall (e.g., aluminum sheet/wall) with embossed features to provide for thermal pad pockets between the sheet/wall and components to assist in cooling; the sheet/wall (e.g., aluminum sheet/wall) is coated with dielectric material for closer installation to electrical components; and/or the insulated isolation barrier wall assembly can contain an electrical fault within the area or side where the fault originated.

While particular embodiments have been described, variations are possible within the scope of the claims.

The term "about" is intended to include the degree of error associated with measurement of the particular quantity based upon the equipment available at the time of filing the application. For example, "about" can include a range of ± 8% or 5%, or 2% of a given value.

The ranges disclosed herein are inclusive of the endpoints, and the endpoints are independently combinable with each other (e.g., ranges of "up to 25 wt.%, or, more specifically, 5 wt.% to 20 wt.%", is inclusive of the endpoints and all intermediate values of the ranges of "5 wt.% to 25 wt.%," etc.). "Combinations" is inclusive of blends, mixtures, alloys, reaction products, and the like. The terms "first," "second," and the like, do not denote any order, quantity, or importance, but rather are used to distinguish one element from another. "Or" means "and/or" unless clearly stated otherwise. Reference throughout the specification to "some embodiments", "an embodiment", and so forth, means that a particular element described in connection with the embodiment is included in at least one embodiment described herein, and may or may not be present in other embodiments. In addition, it is to be understood that the described elements may be combined in any suitable manner in the various embodiments. A "combination thereof is open and includes any combination comprising at least one of the listed components or properties optionally together with a like or equivalent component or property not listed.

The terminology used herein is for the purpose of describing particular embodiments only and is not intended to be limiting of the present disclosure. As used herein, the singular forms "a", "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, element components, and/or groups thereof.

Unless defined otherwise, technical and scientific terms used herein have the same meaning as is commonly understood by one of skill in the art to which this application belongs. All cited patents, patent applications, and other references are incorporated herein by reference in their entirety. However, if a term in the present application contradicts or conflicts with a term in the incorporated reference, the term from the present application takes precedence over the conflicting term from the incorporated reference.

While the present disclosure has been described with reference to an exemplary embodiment or embodiments, it will be understood by those skilled in the art that various changes may be made without departing from the scope of the invention as defined by the claims. In addition, many modifications may be made to adapt a particular situation or material to the teachings of the present disclosure without departing from the scope of the claims. Therefore, it is intended that the present disclosure not be limited to the particular embodiment disclosed as the best mode contemplated for carrying out this present disclosure, but that the present disclosure will include all embodiments falling within the scope of the claims.

## Claims

1. A barrier wall assembly comprising:
a sheet (12) that extends from a first end (13) to a second end (15), the sheet including a first surface (17) and a second surface (19);
a first dielectric material coating (14A) on the first surface, and a second dielectric material coating (14B) on the second surface;
wherein the sheet includes at least one embossed feature (18) extending from the sheet; and
wherein the sheet is configured to be positioned between electrical components (16A, 16B) so that a fault in one section or component functional group will not affect adjacent areas of the components.

2. The assembly of claim 1, wherein the sheet (12) comprises aluminum.

3. The assembly of claim 1 or 2, wherein the first dielectric material coating (14A) comprises a thermally conductive insulator to allow the sheet to assist in conduction cooling of the components, while still having voltage protection for preventing fault propagation.

4. The assembly of any preceding claim, wherein the second dielectric material coating (14B) comprises a liquid or film applied insulation coating that is cured to allow uniform coating thickness on the at least one embossed feature of the sheet, and the liquid or film applied insulation coating provides an arc barrier.

5. The assembly of any preceding claim, wherein the sheet includes a plurality of embossed features (18) extending from the sheet and wherein at least one of the plurality of embossed features includes a pocket (24) having a thermal pad (22) therein to assist in component heat sink cooling.

6. The assembly of any preceding claim, wherein the sheet includes a plurality of embossed features extending from the sheet and wherein at least one of the plurality of embossed features is configured to surround one of the electrical components.

7. The assembly of any preceding claim, wherein the sheet is free from vent holes.

8. A method for fabricating a barrier wall assembly comprising:
providing a sheet (12) that extends from a first end (13) to a second end (15), the sheet including a first surface (17) and a second surface (19);
coating a first dielectric material coating (14A) on the first surface, and coating a second dielectric material coating (14B) on the second surface;
embossing at least one embossed feature (18) on the sheet, the at least one embossed feature extending from the sheet; and
positioning the sheet between electrical components (16A, 16B) so that a fault in one section or component functional group will not affect adjacent areas of the components.

9. A barrier wall assembly comprising:
an isolation sheet (300) that extends from a first end to a second end, the sheet including a first surface (310) and a second surface (312);
a first dielectric material sheet (302) connected to the first surface; and
a second dielectric material sheet (304) connected to the second surface;
wherein at least one of the first and second sheets includes at least one recesses (322, 324) formed therein configured to receive a portion of an electrical component; and
wherein a combination of the isolation sheet and the first and second dielectric material sheets is configured to be positioned in a housing (360) so that a fault in one section of the housing will not affect an adjacent section of the housing.

10. The assembly of claim 9, wherein the first dielectric material sheet or the second material dielectric sheet comprises a thermally conductive insulator to allow the sheet to assist in conduction cooling of the components, while still having voltage protection for preventing fault propagation.

11. The assembly of claim 9 or 10, wherein the isolation sheet is flat.

12. The assembly of any of claims 1 to 7, 9, 10 or 11, in combination with the electrical components, wherein the electrical components include components of different voltages or different criticality, and/or wherein the electrical components comprise power distribution components or equipment, embedded controls, power conversion components, or high voltage motor controllers.

13. A method for fabricating a barrier wall assembly comprising:
providing an isolation sheet (300) that extends from a first end to a second end, the sheet including a first surface (310) and a second surface (312);
connecting a first dielectric material sheet (302) to the first surface;
connecting a second dielectric material sheet (304) to the second surface;
wherein at least one of the first and second sheets includes at least one recess (322, 324) formed therein configured to receive a portion of a printed wiring board; and
positioning the isolation sheet and the dielectric material sheet between electrical components in a housing (360) so that a fault in one section of the housing will not in another section of the enclosure.

14. The method of claim 13, wherein the isolation sheet comprises aluminum.

15. The method of claim 13 or 14, wherein the first dielectric material sheet or the second material dielectric sheet comprises a thermally conductive insulator to allow the sheet to assist in conduction cooling of the components, while still having voltage protection for preventing fault propagation, and optionally wherein the isolation sheet is flat and free from vent holes.
